# EUROPEAN PATENT APPLICATION

(11) **EP 4 290 995 A1**
(43) Date of publication of application: **13.12.2023**
(21) Application number: 22749756.7
(22) Date of filing: 02.02.2022
(51) Int. Cl.: H05K 9/00, B32B 7/025, H01F 1/113, H01Q 17/00, H04B 15/02

(54) **RADIO WAVE ABSORBER AND RADIO WAVE ABSORBING DEVICE**

(30) Priority: 04.02.2021 JP 2021016906; 14.09.2021 JP 2021149155
(71) Applicant: Maxell, Ltd., Kyoto 618-8525 (JP)
(72) Inventor: HIROI, Toshio, Kyoto, 618-8525 (JP); HATAKEYAMA, Atsushi, Kyoto, 618-8525 (JP); FUJITA, Ryohei, Kyoto, 618-8525 (JP)
(74) Representative: Diehl & Partner
(86) International application number: PCT/JP2022/004120
(87) International publication number: WO 2022/168885

(57) **Abstract**

An electric-wave absorber that has sufficient electric-wave absorbing properties in a high frequency band from 20 GHz to 300 GHz and is capable of free-standing while having a certain surface area or more, and an electric-wave absorbing device using this electric-wave absorber are realized. The electric-wave absorber includes an electric-wave absorbing layer 1 and a reinforcing layer 2 disposed on the surface on the electric wave 10 incident side of the electric-wave absorbing layer, and the electric-wave absorbing layer contains at least one of magnetic iron oxide powder 1a and carbon-based fine particles 1b that magnetically resonate in a frequency band of 20 GHz to 300 GHz, and a binder 1c made of resin, the reinforcing layer 2 is constituted by a dielectric material, and the electric-wave absorber has a plate shape with small thickness with respect to its main surface, and is capable of free-standing.

## Description

### Technical Field

The present disclosure relates to an electric-wave absorber that absorbs electric waves and an electric-wave absorbing device using this electric-wave absorber, and in particular, relates to an electric-wave absorber that absorbs electric waves in a high frequency band from 20 gigahertz (GHz) to 300 gigahertz (GHz), which is a so-called millimeter wave band.

### Background Art

Electric-wave absorbers that absorb electric waves have been used to avoid the influence of leaked electric waves emitted to the outside from an electrical circuit or the like, and the influence of electromagnetic waves reflected in an undesired manner being incident on a reception device.

In recent years, research has also advanced regarding technology that uses centimeter waves having a frequency band of several gigahertz (GHz), and furthermore, electric waves having a high frequency in a millimeter-wave band having a frequency of 30 gigahertz to 300 gigahertz in mobile communication such as mobile telephones, wireless LANs, electronic toll collection systems (ETC), and the like.

In response to this technological trend of using electric waves in higher frequency bands, there has been an increase in demand for electric-wave absorbers that absorb unnecessary electric waves from several tens of gigahertz to the millimeter-wave band.

An electromagnetic-wave absorber that has a structure filled with particles having, in a magnetic phase, an epsilon iron oxide (ε-Fe₂O₃) crystal that exhibits an electromagnetic-wave absorption performance in the range of 25 to 100 gigahertz has been proposed as an electromagnetic-wave absorber that absorbs electromagnetic waves in a high frequency band in or above 20 GHz or a millimeter-wave band (30 GHz) (see Patent Document 1). Also, a flat plate-shaped electromagnetic-wave absorber has been proposed which is formed by coating a base made of a metal plate with a paste obtained by kneading fine particles of epsilon iron oxide with a binder (see Patent Document 2).

Also, the inventors have proposed various electric-wave absorbing sheets, which are sheet-shaped electric-wave absorbers that are thin with respect to their surface area, as electric-wave absorbers that favorably absorb electric waves in a high frequency band in or above the millimeter-wave band (Patent Document 3, Patent Document 4).

### Prior Art Documents

### Patent Document

Patent Document 1: JP 2008-60484A
Patent Document 2: JP 2016-111341A
Patent Document 3: Republished International Patent Publication No. WO 2017/221992
Patent Document 4: WO 2018/084235

### Disclosure of Invention

### Problem to be Solved by the Invention

The above-described conventional electric-wave absorbing sheet is formed by dispersing an electric-wave absorbing material in a resin binder, and can be produced as an electric-wave absorbing sheet that is flexible and elastic by selecting the binder material, manufacturing method, and the like. In the case of preventing leakage of electric waves to the outside, the electric-wave absorbing sheet is highly convenient in that it can be easily arranged at a desired located so as to face an incidence direction of electric waves that are to be absorbed, such as being adhered to the inner surface of a housing that covers equipment that is a noise source, or being adhered to an outer surface of a container accommodating a device that is to be protected in the case where avoidance of the influence of electric waves from the outside is desired.

However, since the electric-wave absorbing sheet is thin in relation to its surface area, it is difficult to use while it is free-standing, even if a plastic resin binder is used. On the other hand, a solid block-shaped electric-wave absorber can be processed into a free-standing shape, but it is difficult to obtain an electric-wave absorber with sufficient ease of handling due to the manufacturing becoming large-scale and the weight increasing.

The present disclosure aims to solve the above-described conventional problems, and realize an electric-wave absorber that has at least a certain surface area and is capable of free-standing as an electric-wave absorber having sufficient electric-wave absorbing properties in a high frequency band from 20 GHz to 300 GHz, and an electric-wave absorbing device using this electric-wave absorber.

### Means for Solving Problem

An electric-wave absorber disclosed in the present application for solving the above-described problems includes: an electric-wave absorbing layer; and a reinforcing layer disposed on a surface on an electric-wave incident side of the electric-wave absorbing layer, in which the electric-wave absorbing layer contains a resin binder and at least one of magnetic iron oxide powder and carbon-based fine particles that magnetically resonate in a frequency band of 20 GHz to 300 GHz, the reinforcing layer is constituted by a dielectric material, and the electric-wave absorber has a plate shape with a small thickness with respect to a main surface and is capable of free-standing.

Also, an electric-wave absorbing device disclosed in the present application is an electric-wave absorbing device using the electric-wave absorber disclosed in the present application, the electric-wave absorbing device including: the electric-wave absorber; and a support member capable of keeping the surface on the electric-wave incident side of the electric-wave absorber at a predetermined angle, in which the electric-wave absorber is arranged such that a normal direction of a portion of the surface on the electric-wave incident side located in a traveling direction of electric waves to be absorbed intersects with the traveling direction of the electric waves at a predetermined angle.

### Effects of the Invention

The electric-wave absorber disclosed in the present application can absorb electric waves of a desired frequency due to the electric wave absorption effect resulting from the magnetic resonance of the magnetic iron oxide powder contained in the electric wave absorption layer and the effect of increasing the dielectric loss due to the carbon-based fine particles, and the electric-wave absorber is capable of free-standing despite having a plate shape that is thin with respect to its main surface due to having the reinforcing layer disposed on the surface on the electric-wave incident side. For this reason, it can be easily arranged on the path of electric waves to be absorbed, and the adverse influence of unwanted electric waves can be prevented.

Also, the electric-wave absorbing device disclosed in the present application includes a support member capable of maintaining the electric-wave absorber at a predetermined angle, and can maintain a state in which the surface on the electric-wave incident side is inclined with respect to the traveling direction of the electric waves to be absorbed. For this reason, it is possible to realize an electric-wave absorbing device with a high reflection attenuation amount that suppresses the influence of electric waves reflected on the surface of the reinforcing layer.

### Brief Description of Drawings

[FIG. 1] FIG. 1 is a cross-sectional configuration diagram illustrating a configuration of an electromagnetic-wave absorber according to an embodiment.
[FIG. 2] FIG. 2 is an image diagram illustrating a method for an evaluation test for evaluating a free-standing ability of the electromagnetic-wave absorber according to the embodiment.
[FIG. 3] FIG. 3 is a diagram showing a use state of the electric-wave absorbing device according to the embodiment.
[FIG. 4] FIG. 4 is an image diagram showing a state of measuring a relationship between an inclination angle of the electric-wave incident surface of the electric-wave absorber and electric-wave absorbing properties.
[FIG. 5] FIG. 5 is a diagram showing changes in electric-wave absorbing properties depending on the inclination angle of the electric-wave incident surface of the electric-wave absorber.
[FIG. 6] FIG. 6 is a diagram showing changes in electric-wave absorbing properties depending on the inclination angle of the electric-wave incident surface of the electric-wave absorber.
[FIG. 7] FIG. 7 is a diagram showing changes in electric-wave absorbing properties depending on the inclination angle of the electric-wave incident surface of the electric-wave absorber.

### Description of the Invention

The electric-wave absorber disclosed in this application includes: an electric-wave absorbing layer; and a reinforcing layer disposed on a surface on an electric-wave incident side of the electric-wave absorbing layer, in which the electric-wave absorbing layer contains a resin binder and at least one of magnetic iron oxide powder and carbon-based fine particles that magnetically resonate in a frequency band of 20 GHz to 300 GHz, the reinforcing layer is constituted by a dielectric material, and the electric-wave absorber has a plate shape with a small thickness with respect to a main surface and is capable of free-standing.

By doing so, the electric-wave absorber disclosed in the present application can be easily arranged so as to shield the path along which the electric waves to be absorbed travel, and it is possible to easily avoid adverse effects resulting from unwanted electric waves when, for example, measuring electric-wave properties of a device.

In the electric-wave absorber having the above configuration, it is preferable that the magnetic iron oxide powder is either magnetoplumbite-type ferrite powder or epsilon magnetic iron oxide powder, and furthermore, that the carbon-based fine particles are at least one of carbon black, carbon nanotubes, and graphene. By using these members as electric-wave absorbing members for absorbing electric waves in the electric-wave absorbing layer, high electric-wave absorbing properties can be realized in the frequency band from 20 GHz to 300 GHz.

Furthermore, it is preferable that the resin binder is a rubber-based member. By using a binder of a rubber material, it is possible to easily form an electric-wave absorbing layer having a main surface with a large surface area.

Also, it is preferable that in a free-standing ability test for the electromagnetic-wave absorber, a Δ value indicating a degree of deformation of an electric-wave absorber sample is 0.5 mm or less. In this case, it can be evaluated that the electric-wave absorber is capable of free-standing.

Furthermore, it is preferable that an electric-wave attenuation amount for transmitted electric waves passing through the electric-wave absorber is -10 dB or more. Due to having electric-wave absorbing properties such that the electric-wave attenuation amount for transmitted electric waves is -10 dB or more, that is, the absolute value of the transmission attenuation amount (dB) is 10 or more, the electric-wave absorber can be used as an electric-wave absorber that can sufficiently reduce the influence of unwanted electric waves.

The reinforcing layer can be formed by including one selected from a reinforcing plate material having a honeycomb structure, a foam plate material, plastic cardboard, and a plastic plate material.

The electric-wave absorbing device disclosed in this application is an electric-wave absorbing device using the electric-wave absorber disclosed in the present application, the electric-wave absorbing device including: the electric-wave absorber; and a support member capable of keeping the surface on the electric-wave incident side of the electric-wave absorber at a predetermined angle, in which the electric-wave absorber is arranged such that a normal direction of a portion of the surface on the electric-wave incident side located in a traveling direction of electric waves to be absorbed intersects with the traveling direction of the electric waves at a predetermined angle.

Note that in this specification, the normal direction of the surface portion of the electric-wave incident surface and the traveling direction of the electric waves "intersecting at a predetermined angle" means that the normal direction of the portion of the surface of the electric-wave incident surface and the traveling direction of the electric waves do not overlap, that is, the two intersect at an angle greater than 0°.

By doing so, the electric-wave absorbing device disclosed in the present application can keep the electric-wave incident surface of the electric-wave absorber in a state of being inclined at a desired angle, and in particular, it is possible to realize an electric-wave absorbing device with a high reflection attenuation amount in which reflection of electric waves on the surface of the reinforcing layer is suppressed.

In the electric-wave absorbing device having the above configuration, it is preferable that a portion of the surface is a curved surface curved in at least one direction. If the surface is a curved surface, it is possible to reduce the amount of electric waves reflected in the electric-wave incidence direction and to improve the reflection attenuation amount.

Also, it is preferable that an angle at which a normal direction of the portion of the surface intersects with the travel direction of the electric waves is 2° or more and 20° or less, and it is more preferable that the intersecting angle is 3° or more and 7° or less.

Hereinafter, the electric-wave absorber disclosed in the present application will be described with reference to the drawings.

### Embodiments

An electric-wave absorber that contains, in an electric-wave absorbing layer, as electric-wave absorbing members, strontium ferrite serving as a magnetic iron oxide powder and carbon black serving as carbon-based fine particles, and silicone rubber as a resin binder, and that includes a plastic sheet having a polypropylene honeycomb structure as a reinforcing layer, will be illustrated and described as an embodiment of an electric-wave absorber disclosed in the present application.

### [Configuration of Electric-Wave Absorber]

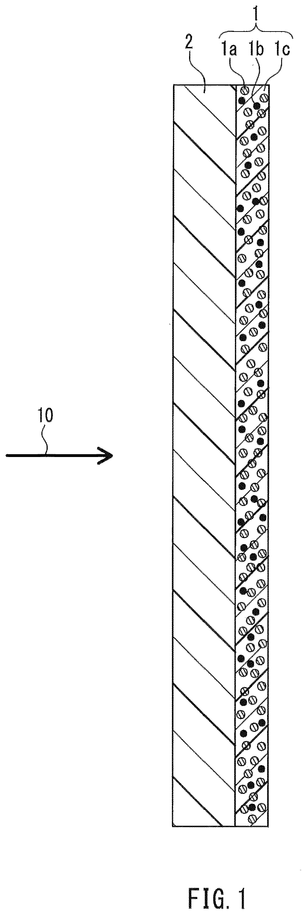

FIG. 1 is a cross-sectional view showing a configuration of the electric-wave absorber described in this embodiment.

As shown in FIG. 1, the electric-wave absorber according to the present embodiment has an electric-wave absorbing layer 1 in which strontium ferrite powder 1a and carbon black fine particles 1b serving as electric-wave absorbing members are dispersed and arranged in a silicone rubber binder 1c, and a reinforcing layer 2, which is a plastic sheet having a honeycomb structure that is arranged on the surface on the side of the electric-wave absorbing layer on which electric waves 20 are incident.

In addition, the electric-wave absorber according to the present embodiment has a thickness, which is the sum of the thicknesses of the electric-wave absorbing layer 1 and the reinforcing layer 2, that is sufficiently smaller than the surface areas (main surface areas) of the electric-wave absorbing layer 1 and the reinforcing layer 2, and the electric-wave absorber has an overall shape that is board-shaped, which is called an electric-wave absorbing board. More specifically, the thickness of the electric-wave absorbing layer 1 is, for example, about 1 mm to 5 mm, while the thickness of the reinforcing layer 2 is about 5 mm to 30 mm. Note that the main surfaces of the electric-wave absorbing layer 1 and the reinforcing layer 2 are, for example, formed as rectangles (rectangles or squares) with sides of several centimeters to several tens of centimeters or several meters.

The electric-wave absorber 1 according to this embodiment has a reinforcing layer 2 disposed on the electric-wave incident side of the electric-wave absorbing layer 1, and is capable of free-standing. Here, "free-standing" means that the shape of the electric-wave absorber does not change when the electric-wave absorber is stood upright with the main surface of the electric-wave absorber as a side surface (so as to face the side), that is, when the electric-wave absorber is disposed such that the thickness of a portion corresponding to one side of the main surface of the electric-wave absorber becomes the bottom surface, and such that the main surface of the electric-wave absorber is vertical on a horizontal flat surface. Note that there is no problem in using support members or legs for maintaining the electric-wave absorber in the free-standing state, and the term "free-standing" in the present specification does not mean only a single electric-wave absorber being stood upright with the main surface vertical. Also, the main surface of the electric-wave absorber need only be kept substantially vertical, and the state in which the electric-wave absorber is free-standing also encompasses a case of maintaining a state in which the electric-wave absorber is leaned against something, that is, a state in which the support member is in contact with a portion in the vicinity of the upper end portion or the back surface portion of the electric-wave absorber (the side opposite to the side on which the reinforcing layer 2, on which electric waves are incident, is disposed) and the main surface of the electric-wave absorber is slightly inclined with respect to the vertical direction.

In the electric-wave absorber according to the present embodiment, the electric-wave absorbing layer 1 and the reinforcing layer 2 need only be formed such that the two are integrated with each other and the integration thereof is not lost even when the electric-wave absorber is free-standing. For this reason, the electric-wave absorber can be formed by separately producing the electric-wave absorbing layer 1 and the reinforcing layer 2 and adhering them together using an adhesive means such as a silicone-based adhesive or double-sided tape. In addition, in a state in which the electric-wave absorbing layer 1 and the reinforcing layer 2 are overlapped in areal contact with each other, the electric-wave absorber can be formed by integrating the electric-wave absorbing layer 1 and the reinforcing layer 2 with each other using a mechanical integration means such as pinning, riveting, or screwing at multiple locations, or sandwiching the surrounding area in a frame shape.

### [Electric-Wave Absorbing Layer]

The electric-wave absorbing layer of the electric-wave absorber according to this embodiment is formed by dispersing and mixing together strontium ferrite powder 1a and carbon black powder 1b, which are electric-wave absorbing members, in a binder 1c made of resin.

Note that in this embodiment, a resin binder is described in which both the strontium ferrite powder, which is the magnetic iron oxide powder, and the carbon black powder, which is the carbon-based fine particles, are included, but it is possible to use a configuration in which the resin binder contains only the magnetic iron oxide powder or the carbon-based fine particles.

The main surface of the electric-wave absorbing layer is set such that one or more are arranged to have a surface area that can block unwanted electric waves with consideration given to the path of the electric waves to be blocked by the electric-wave absorber, the emission angle of unwanted electric waves from a device or the like that is a noise source, the incidence angle of the electric waves from the outside to the protection target device that is to be protected from unwanted electric waves, and the like. The thickness of the electric-wave absorbing layer is set based on the type of electric-wave absorbing material contained, the density at which the material is contained in the electric-wave absorbing layer, and the like, and is set to a thickness with which unnecessary electric waves can be sufficiently absorbed. Note that, in general, if the electric-wave absorber as a whole can attenuate unwanted electric waves to 1/10, it can be considered that the minimum electric wave absorption effect is exhibited, and therefore it is preferable that the electric-wave absorbing properties of the electric-wave absorber are set such that the transmission attenuation amount, which is the amount of attenuation of the electric waves passing through the electric-wave absorber, is 10 dB.

Specifically, as an example, if an electric-wave absorbing layer that absorbs electric waves of 76.5 GHz is produced using strontium ferrite and carbon black as electric-wave absorbing materials and silicone rubber as a binder, the thickness can be set to about 1 mm to 4.5 mm.

In the electric-wave absorber according to the present embodiment, a reinforcement layer, which will be described later, is arranged on the electric-wave incident side of the electric-wave absorbing layer so that the electric-wave absorber is capable of free-standing, and therefore there is no restriction on the rigidity and strength of a single electric-wave absorbing layer. For this reason, it is permissible to use a material that is easily deformed in a single electric-wave absorbing layer, such as using a soft rubber-based member such as silicone rubber or natural rubber as a binder.

### (Magnetic Iron Oxide Powder)

Powders of magnetoplumbite-type ferrite and epsilon magnetic iron oxide that cause magnetic resonance with respect to electric waves in the frequency band of 20 GHz to 300 GHz are favorably used as the magnetic iron oxide powder used in the electric-wave absorber according to the present embodiment.

Magnetic powder of strontium ferrite (Sr-Fe) or barium ferrite (Ba-Fe) can be used as the magnetoplumbite-type (M-type) ferrite.

In magnetoplumbite-type ferrite, an imaginary part (pr") of a complex magnetic permeability related to electric-wave absorption becomes high at a frequency at which resonance occurs when a magnetic material is magnetized at a high frequency. Since the natural resonance frequency f is proportional to the anisotropic magnetic field H_{A} of the material, the higher the anisotropic magnetic field H_{A} of the material is, the higher the natural resonance frequency f is. The natural resonance frequency f of barium ferrite (BaFe₁₂O₁₉) is calculated to have an H_{A} value of 48 GHz from 1.35 MA/m, and barium ferrite can absorb electromagnetic waves in a high GHz band.

Also, by substituting a portion of Fe³⁺ with (TiMn)³⁺ or Al³⁺, the value of the anisotropic magnetic field H_{A} can be controlled to control the natural resonance frequency f within the range of 5 to 150 GHz.

For example, by adding Al to strontium ferrite (SrFe₁₂O₁₉), an electric-wave absorber compatible with a wireless LAN in the 60 GHz band can be obtained.

Epsilon magnetic iron oxide (ε-Fe₂O₃) can be used as the magnetic iron oxide powder used in the electric-wave absorber according to this embodiment.

The epsilon phase of epsilon magnetic iron oxide is a phase that appears between the alpha phase (α-Fe₂O₃) and the gamma phase (γ-Fe₂O₃) in ferric oxide (Fe₂O₃). Epsilon magnetic iron oxide is a magnetic material that can be obtained in a single-phase state through a nanoparticle synthesis method in which a reverse micelle method and a sol-gel method are combined. Epsilon magnetic iron oxide is a fine particle of several nm to several tens of nm but has a coercive force of about 20 kOe at room temperature, which is the largest coercive force among metal oxides. Furthermore, the natural magnetic resonance due to a gyromagnetic effect obtained based on the precession occurs in a frequency band of several tens of GHz or higher, which is a so-called millimeter-wave band, and therefore epsilon magnetic iron oxide is favorable as an electric-wave absorbing material that absorbs electric waves in a millimeter-wave band.

Furthermore, due to epsilon magnetic iron oxide being a crystal in which part of the Fe site of the crystal is replaced with a trivalent metal element such as aluminum (Al), gallium (Ga), rhodium (Rh), or indium (In), the magnetic resonance frequency can be varied. Therefore, by adjusting the type and the amount of the metal to be substituted, the electric-wave absorber can handle the frequency of electric waves that are to be absorbed by the electric-wave absorber.

Note that epsilon magnetic iron oxide is available along with epsilon magnetic iron oxide in which at least one of the Fe sites is replaced with a metal. Epsilon magnetic iron oxide is available as approximately spherical or short rod-shaped particles with an average particle size of about 30 nm.

### (Carbon-Based Fine Particles)

In the electric-wave absorber according to this embodiment, the electric-wave absorbing layer has carbon-based fine particles alone or together with the magnetic iron oxide powder described above.

Carbon black (CB), carbon nanotubes (CNT), or graphene is preferably used for the carbon-based fine particles. Note that any one of these types of carbon-based fine particles may be used alone, or two or more of them may be used in combination.

More specifically, various conductive carbon blacks such as conductive furnace carbon black, acetylene black, and ketjen black can be used as the carbon black. Both single-wall nanotubes (SWNT) and multi-wall nanotubes (MWNT) can be used as the carbon nanotubes. Also, graphene is a carbon material having a sheet-like structure with a thickness of one atom, in which a honeycomb-shaped hexagonal lattice formed by sp2 bonds of carbon atoms is laid out in a planar shape. Strictly speaking, graphene refers to a single-layer sheet as described above, but graphene used for the electric-wave absorbing layer described in this embodiment also includes, for example, carbon films having 2 to 1000 layers stacked. Furthermore, graphene also includes graphite obtained by stacking graphene three-dimensionally.

Carbon-based fine particles having a specific surface area of 30 to 2300 m²/g can be used, and preferably, carbon-based fine particles having a specific surface area of 300 to 2000 m²/g, and even more preferably carbon-based fine particles having a specific surface area of 800 to 1800 m²/g are used. Carbon black preferably has a primary particle diameter of 10 to 60 nm and a BET value of 300 to 1500 m²/g. Also, the carbon nanotubes preferably have a diameter of 3 to 50 nm, a length of 3 to 100 µm, and a BET value of 10 to 1200 m²/g.

### (Binder)

Resin materials such as epoxy resin, polyester resin, polyurethane resin, acrylic resin, phenol resin, melamine resin, and rubber resin can be used as the binder used in the electric-wave absorbing layer of the electric-wave absorber according to this embodiment.

More specifically, a compound obtained by epoxidizing hydroxyl groups at both ends of bisphenol A can be used as the epoxy resin. Also, polyester-based urethane resin, polyether-based urethane resin, polycarbonate-based urethane resin, epoxy-based urethane resin, and the like can be used as the polyurethane resin. A methacrylic resin such as a functional-group-containing methacrylic polymer or the like obtained by copolymerizing an acrylic acid alkyl ester and/or methacrylic acid alkyl ester in which the alkyl group has 2 to 18 carbon atoms, a functional-group-containing monomer, and, if necessary, another modifying monomer that is copolymerizable with these can be used as the acrylic resin.

Also, various kinds of rubber materials can be used as the rubber-based resin. Examples of the rubber materials include natural rubber (NR), isoprene rubber (IR), butadiene rubber (BR), styrene-butadiene rubber (SBR), butyl rubber (IIR), nitrile rubber (NBR), ethylene-propylene rubber (EPDM), chloroprene rubber (CR), acrylic rubber (ACM), chlorosulfonated polyethylene rubber (CSR), urethane rubber (PUR), silicone rubber (Q), fluororubber (FKM), ethylene-vinyl acetate rubber (EVA), epichlorohydrin rubber (CO), polysulfide rubber (T), and urethane rubber (U).

Also, based on the definition of rubber as a material having rubber elasticity at room temperature, for example, thermoplastic elastomers such as styrene thermoplastic elastomers (SIS) can be used as the binder of the electric-wave absorbing layer of the electric-wave absorber described in this embodiment, since they have fluidity at high temperatures but have rubber elasticity at room temperature.

Among these rubber materials, acrylic rubber and silicone rubber are preferable due to having high heat resistance. Acrylic rubber offers excellent oil resistance even in high temperature environments while being relatively inexpensive and cost-effective. Silicone rubber offers not only high heat resistance but also high cold resistance. Moreover, the physical properties of silicone rubber are the most temperature-independent among synthetic rubbers, and silicone rubber offers excellent solvent resistance, ozone resistance, and weather resistance. Furthermore, silicone rubber has excellent electrical insulation properties while being physically stable in a wide temperature range and a wide frequency region.

Note that when using a heat-resistant thermoplastic resin having a high melting point as the thermoplastic resin to form the electric-wave absorber as a molded body, aromatic polyamides such as 6T nylon (6TPA), 9T nylon (9TPA), 10T nylon (10TPA), 12T nylon (12TPA), and MXD6 nylon (MXDPA) and their alloy materials, polyphenylene sulfide (PPS), liquid crystal polymer (LCP), polyether ether ketone (PEEK), polyetherimide (PEI), polyphenylsulfone (PPSU), polystyrene (PS), styrene-butadiene-acrylonitrile copolymer (ABS), polypropylene (PP), polyacetal (POM), polybutylene terephthalate (PBT), polycarbonate (PC), and the like can be used.

Also, from the viewpoint of consideration for the environment, it is preferable to use a halogen-free resin that does not contain halogen, as the resin used as the binder. These resin materials are commonly used as binder materials for resin sheets and thus are readily available.

Furthermore, in order to favorably disperse magnetoplumbite-based ferrite and epsilon magnetic iron oxide, which are electric-wave absorbing members, in the binder, phosphate compounds such as aryl sulfonic acids such as phenylphosphonic acid and phenylphosphonic dichloride, alkyl phosphonic acids such as methylphosphonic acid, ethylphosphonic acid, octylphosphonic acid, and propylphosphonic acid, or polyfunctional phosphonic acids such as hydroxyethane diphosphonic acid and nitrotrismethylene phosphonic acid can be included as dispersants.

More specifically, as the dispersant, phenylphosphonic acid (PPA) manufactured by Wako Pure Chemical Industries, Ltd. or Nissan Chemical Industries, Ltd., oxidized phosphoric acid ester "JP-502" (product name) manufactured by Johoku Chemical Industry Co., Ltd., or the like can be used.

Note that when magnetoplumbite-type ferrite is used as the composition of the electric-wave absorbing layer, for example, 2 to 120 parts of a resin binder and 0.1 to 15 parts of a phosphate compound can be included with respect to 100 parts of the magnetoplumbite-type ferrite. In the case of using epsilon iron oxide, for example, 2 to 50 parts of the resin binder and 0.1 to 15 parts of the phosphate compound can be included with respect to 100 parts of the epsilon magnetic iron oxide powder. If the amount of the resin binder is small, the magnetic iron oxide cannot be favorably dispersed. Also, the sheet-like shape of the magnetic layer cannot be maintained. If the amount of the resin binder is large, the volume content of the magnetic iron oxide in the electric-wave absorbing layer will be small, and the magnetic permeability will be low, and therefore the electric-wave absorption effect will be small.

Also, when carbon black is used for the carbon-based fine particles, for example, 300 to 700 parts of the resin binder can be used with respect to 100 parts of the carbon black. When using carbon nanotubes or graphene, for example, 300 to 2500 parts of resin binder can be used with respect to 100 parts of carbon black or carbon nanotubes.

### (Method for Manufacturing Electric-Wave Absorbing Layer)

The electric-wave absorbing layer of the electric-wave absorber of the present embodiment can be formed by, for example, producing a magnetic paint containing magnetic iron oxide powder and a resin binder, applying the magnetic paint at a predetermined thickness, drying it, and then calendering it.

As the magnetic paint, a magnetic paint can be obtained also by mixing a magnetic iron oxide powder, a phosphate compound that is a dispersant, and a binder resin together at high speed with a high-speed stirring machine to prepare a mixture, and then dispersing the resulting mixture with a sand mill.

An electric-wave absorbing layer is produced using the magnetic paint produced in this manner.

For example, the magnetic paint prepared above is applied onto a base sheet made of resin. As an example of the resin sheet, a polyethylene terephthalate (PET) sheet having a thickness of 38 µm and a surface that has been subjected to peeling treatment with a silicone coat can be used. A magnetic paint is applied onto this resin sheet using a coating method such as a table coater method or a bar coater method.

Thereafter, the wet magnetic paint can be dried and further calendered to form a sheet-like electric-wave absorbing layer on the support. The thickness of the electric-wave absorbing layer can be controlled using the coating thickness, calendering conditions, and the like. After the calendering, the electric-wave absorbing layer is peeled off from the resin sheet to obtain an electric-wave absorbing layer having a desired thickness.

Note that calendering need only be performed as necessary, and calendering need not be performed when the volume content of the electric-wave absorbing material is within a predetermined range when the magnetic paint is dried.

As another method for manufacturing the electric-wave absorbing layer, magnetic iron oxide powder and/or carbon-based fine particles are kneaded with a resin binder, the resulting kneaded product is mixed with a cross-linking agent to adjust the viscosity, and the resulting magnetic compound is cross-linked, molded, and pressed into a sheet shape at a temperature of 165°C using, for example, a hydraulic press or the like, and then is subjected to a secondary crosslinking treatment in a constant temperature bath to form an electric-wave absorbing layer.

Note that molding can be performed through extrusion molding or injection molding, in addition to the above-described press-molding. More specifically, an electric-wave absorbing substance, a resin binder, and as needed, a dispersant, and the like are blended in advance using a pressurizing kneader, an extruder, a roll mill, or the like, and these blended materials are supplied into a plastic cylinder from a resin supply port of an extrusion molding machine. Note that a typical extrusion molding machine including a plastic cylinder, a die provided at the leading end of the plastic cylinder, a screw provided so as to be able to rotate in the plastic cylinder, and a drive mechanism for driving the screw can be used as the extrusion molding machine. A molten material plasticized using a band heater of the extrusion molding machine is sent forward due to the rotation of the screw, and is extruded from the leading end in the form of a sheet, whereby an electromagnetic-wave absorbing layer with a predetermined thickness can be obtained.

Also, an electric-wave absorbing substance, a dispersant, and a binder are preblended as needed, the blended materials are supplied into a plastic cylinder from a resin supply port of an injection molding machine, and melted and kneaded with a screw in a plastic cylinder, and then a molded body can be formed by injecting molten resin into a mold connected to the leading end of the injection molding machine.

Note that when a rubber-based resin material is used as the resin binder, it is possible to use a roll-to-roll method in which molding is performed while moving between two rolls. By using the roll-to-roll method, it is possible to produce a sheet-like electric-wave absorbing layer with a width of about 1 m to 3 m, and it is possible to more easily produce an electric-wave absorbing layer with a large area compared to molding methods such as extrusion molding described above.

### [Reinforcing Layer]

The reinforcing layer is a molded body of a dielectric material, and is a plate-shaped member having a small thickness with respect to the area of the main surface. However, when it is arranged on the electric-wave incident side of the electric-wave absorbing layer and configured as an electric-wave absorber, it must free-stand with its main surface as a side surface, and therefore it must have a certain thickness to ensure the rigidity that allows it to free-stand. On the other hand, if the reinforcing layer is heavy, the overall weight of the electric-wave absorber increases, and therefore it is preferable that its weight is reduced as much as possible while having a certain rigidity.

As a dielectric member having such requirements, in the electric-wave absorber according to the present embodiment, Teccell (product name, manufactured by Gifu Plastic Industry Co., Ltd.), which is a honeycomb core material made of polypropylene (PP), can be favorably used in the reinforcing layer. Teccell has a honeycomb structure sandwiched between two thin flat layers, and therefore is lightweight while having high strength (rigidity). Also, Teccell is commercially available at a thickness of 5 mm to 30 mm, a maximum width of 1250 mm, and a maximum length of 2500 mm, and can be easily obtained with a desired shape according to the surface shape and size of the electric-wave absorbing layer.

Note that, in addition to the honeycomb core material described above, various resin boards can be used as the reinforcing layer of the electric-wave absorber according to the present embodiment. For example, Paronia (registered trademark, manufactured by Mitsui Chemicals Tohcello, Inc.), which is foam-molded polypropylene, is formed by extruding and foam-molding polypropylene to about three times its original size, and is used as a plate material for a container case as an alternative to plywood. For this reason, it can be effectively used in a reinforcing layer as a plate material made of a dielectric having a light specific gravity and at least a certain level of strength.

Furthermore, plastic cardboard using polypropylene can also be used in the reinforcing layer as a member having a certain rigidity while being lightweight.

Also, the above-mentioned reinforcing plate material, foam plate material, and plastic cardboard with the honeycomb structure are all characterized by having cavities inside the plate material, which reduces weight, and are characterized by having low permittivity in the plate material due to containing air.

In the electric-wave absorber according to this embodiment, the reinforcing layer is arranged on the surface of the electric-wave absorbing layer on which electric waves are incident. At this time, since the dielectric constant of the reinforcement layer is sufficiently low, reflection of incident electric waves on the surface of the reinforcement layer is reduced, and more electric waves enter the electric-wave absorbing layer and are absorbed by the electric-wave absorbing layer. Also, by suppressing reflection on the surface of the reinforcing layer, for example, when measuring the electric-wave properties of a transmitting/receiving device such as radar, it is possible to effectively suppress a case in which the electric waves emitted from the transmission unit are reflected on the surface of the electric-wave absorber and are received by the receiving unit, and it is possible to measure the electric-wave properties at a high S/N ratio.

In addition, although it is not a member having a cavity, a plate material made of plastic such as an acrylic plate or a polycarbonate plate can also be used for the reinforcing layer. However, a plate material that does not have cavities has a large specific gravity, and the weight increases in a reinforcing layer to which an electric-wave absorbing layer with a large surface area is fixed. Also, when the electric-wave absorber is allowed to free-stand, it may bend under its own weight, and therefore it is an effective material as a reinforcing layer used together with an electric-wave absorbing layer having a main surface with a relatively small surface area.

According to studies conducted by the inventors, it was confirmed that if the reinforcing layer has a bending strength of 3 MPa or more according to the bending fracture test method, a flexible electric-wave absorbing layer that can be easily bent like an electric-wave absorbing layer using a rubber material as a binder can obtain practically sufficient rigidity by which the electric-wave absorber is capable of free-standing when combined with the above-described reinforcing layer.

Also, from the viewpoint that the electric-wave absorbing properties of the electric-wave absorber do not change even after long-term use, it is conceivable that the dielectric material used as the reinforcing layer desirably has a water absorption rate of 1.5% or less.

### [Measuring Free-Standing Ability]

As described above, the electric-wave absorber according to the present embodiment is capable of free-standing because its main surface can be kept in a state of being arranged substantially in the vertical direction. In view of this, the inventors devised an evaluation method for quantifying and evaluating the degree of free-standing ability of the electric-wave absorber according to this embodiment.

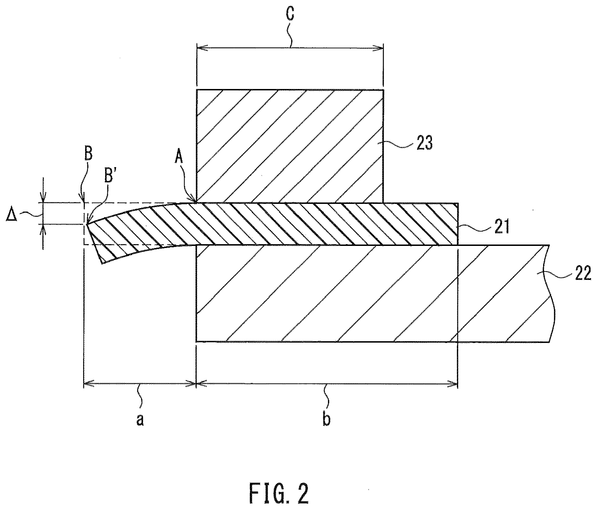

FIG. 2 is a model diagram for describing a measurement method for evaluating the free-standing ability of the electric-wave absorber according to this embodiment.

In the method for measuring the free-standing ability shown in FIG. 2, an electric-wave absorber 21 having a width of 25 mm and a length of 100 mm is used as a sample. This sample 21 is placed on a hard platform 22 made of metal, plastic, or the like, with the reinforcing layer 2 facing downward, such that the lengthwise direction of the sample side 21 is perpendicular to the edge of the platform 22, and such that the sample protrudes from the edge of the platform 22 by a length a (=30 mm). Then, a weight 23 is placed on the portion of the remaining length b (=70 mm) on the platform 22. The weight 23 is a cuboid with a width of 25 mm and a length of c=50 mm, and its height is optional, but its weight is 5 kg. The end of this weight 23 is arranged so as to coincide with the edge of the platform 22. With the weight 23 placed on the sample 21, the sample is left in a room-temperature (=25° C) environment for 10 minutes.

After 10 minutes have passed, a difference Δ between the height of the leading end portion of the upper surface of the sample 21 (B' in the drawing) and the height of B when the sample 21 is not deformed (the same height as the upper surface A of the sample 21 at the end of the platform 22) is measured.

If the Δ value obtained in this manner, which indicates the degree of deformation of the electric-wave absorber sample, is 0.5 mm or less, it is evaluated as being capable of free-standing.

### [Measurement Result of Electric-Wave Absorber]

Hereinafter, the details of studies in which the electric-wave absorber according to this embodiment is actually produced and the electric-wave absorbing properties and free-standing ability thereof are measured and evaluated will be described.

### <Electric-Wave Absorbing Layer>

As the electric-wave absorbing layer, an electric-wave absorbing layer was produced in which strontium ferrite magnetic powder was used as the magnetic iron oxide powder and the type of the carbon-based fine particles was changed. Note that silicone rubber was used as the binder in each case.

The electromagnetic-wave absorbing layer was produced by press-molding a magnetic compound with a predetermined thickness. The magnetic compound was obtained by kneading a magnetic iron oxide powder, a rubber binder, and carbon-based fine particles, and mixing a cross-linking agent with the resulting kneaded product to adjust the viscosity. A desired electric-wave absorbing layer having the thickness shown below was obtained by cross-linking and molding the magnetic compound produced in this manner into a sheet shape at a temperature of 165°C using a hydraulic press, and then performing a secondary crosslinking treatment at a temperature of 170°C in a constant temperature bath.

The materials and amounts of the magnetic iron oxide powder, the carbon-based fine particles, and the rubber binder used when forming the magnetic compound were as follows.

### Electric-wave absorbing layer 1

| | |
|---|---|
| Magnetic iron oxide: Strontium ferrite magnetic powder | 65 parts by weight |
| Carbon-based fine particles: Carbon black | 1.5 parts by weight |
| Binder: Silicone rubber: KE-541-U | 33 parts by weight |
| Cross-linking agent | 0.5 parts by weight |

### Electric-wave absorbing layer 2

| | |
|---|---|
| Magnetic iron oxide: Strontium ferrite magnetic powder | 65 parts by weight |
| Carbon-based fine particles: Carbon nanotubes | 1.5 parts by weight |
| Binder: Silicone rubber: KE-541-U | 33 parts by weight |
| Cross-linking agent: | 1 part by weight |

### Electric-wave absorbing layer 3

| | |
|---|---|
| Magnetic iron oxide: Strontium ferrite magnetic powder | 65 parts by weight |
| Binder: Silicone rubber: KE-541-U | 34 parts by weight |
| Cross-linking agent: | 1 part by weight |

### Electric-wave absorbing layer 4

| | |
|---|---|
| Carbon-based fine particles: Carbon black | 6 parts by weight |
| Binder: Silicone rubber: KE-541-U | 92 parts by weight |
| Cross-linking agent: | 2 parts by weight |

Strontium ferrite magnetic powder having an average particle diameter of 2.2 µm and a BET value of 1.5 m²/g was used as each material of the electric-wave absorbing layer. Ketjenblack EC600JD (product name) manufactured by Lion Specialty Chemicals Co., Ltd. having a primary particle diameter of 34 nm and a BET value of 1400 m²/g was used. As the carbon nanotube, VGCF-H (product name) manufactured by Showa Denko K.K. with a fiber diameter of 150 nm and a BET value of 13 m²/g was used.

Silicone rubber KE-541-U (product name) used as a binder is a silicone rubber manufactured by Shin-Etsu Chemical Co., Ltd. As a cross-linking agent, 2.5 dimethyl-2.5 bis(tertiary-butylperoxy)hexane (C-8A (product name) manufactured by Shin-Etsu Chemical Co., Ltd.) was used.

As the reinforcing layers, the above-described honeycomb core material made of polypropylene (Teccell (product name, manufactured by Gifu Plastic Industry Co., Ltd.)) having a thickness of 9.7 mm (reinforcing layer 1) and having a thickness of 7.7 mm (reinforcing layer 2), and a polypropylene foam molded body (Paulownia (registered trademark, manufactured by Mitsui Chemicals Tbhcello Co., Ltd.)) with a thickness of 6.0 mm (reinforcing layer 3), an acrylic plate with a thickness of 10.0 mm (reinforcing layer 4), and pladan (polypropylene) with a thickness of 10.0 mm (reinforcing layer 5) were prepared.

Regarding Examples 1 to 8 of the electric-wave absorber in which the electric-wave absorbing layers 1 to 4 and the reinforcing layers 1 to 5 are combined, and Comparative Example 1 having no reinforcing layer, a free-standing ability evaluation value (Δ) was measured, and as the electric-wave absorbing properties of the electric-wave absorber, the reflection attenuation properties (reflection attenuation amount) on the surface of the reinforcing layer and the attenuation amount (transmission attenuation amount) when the electric waves incident on the electric-wave absorber pass through the electric-wave absorber were measured.

Specific combinations of each embodiment are as follows: the electric-wave absorbing layer 1 and the reinforcing layer 1 were combined in Example 1, the electric-wave absorbing layer 1 and the reinforcing layer 2 were combined in Example 2, the electric-wave absorbing layer 1 and the reinforcing layer 3 were combined in Example 3, the electric-wave absorbing layer 3 and the reinforcing layer 1 were combined in Example 4, the electric-wave absorbing layer 1 and the reinforcing layer 4 were combined in Example 5, the electric-wave absorbing layer 2 and the reinforcing layer 1 were combined in Example 6, the electric-wave absorbing layer 1 and the reinforcing layer 5 were combined in Example 7, and the electric-wave absorbing layer 4 and the reinforcing layer 1 were combined in Example 8, and in each Example, an electric-wave absorbing layer and a reinforcing layer each with a width of 25 mm and a length of 100 mm were adhered to each other with double-sided tape to form a sample of the electric-wave absorber. Also, in Comparative Example 1, the electric-wave absorbing layer 1 was used as the electric-wave absorbing layer.

Note that the reflection attenuation amount and transmission attenuation amount of electric waves were both measured using a free space method. Specifically, millimeter-wave network analyzer ME7838A (product name) manufactured by Anritsu Corporation was used to emit input waves of 76.5 GHz to the electric-wave incident side, which is the front surface side of the electric-wave absorber, that is, the side on which the reinforcing layer is arranged, from a transmitting antenna through a dielectric lens. At this time, the surface reflected wave reflected by the front surface of the electric-wave absorber and the transmitted wave penetrating to the back surface side of the electric-wave absorber, that is, the electric-wave absorbing layer side, were respectively measured by arranging receiving antennas. The intensity of the electric waves emitted from the transmitting antenna and the intensity of the electric waves received by the receiving antenna were respectively measured as voltage values, and the reflection attenuation amount at the electric-wave absorbing surface was obtained in dB based on "emitted waves - reflected waves", and the transmission attenuation amount was obtained in dB based on "emitted waves - transmitted waves".

Table 1 shows the above measurement results.

**[Table 1]**

| | Electric-wave absorbing layer | | | | Reinforcing layer | | | Overall electric-wave absorber | |
|---|---|---|---|---|---|---|---|---|---|
| | Electric-wave absorbing substance | | Binder | Thickness (mm) | Material | Thickness (mm) | Reflection attenuatio n amount (dB) | Free-standing ability evaluation result (Δ value) | Transmission attenuation amount (dB) |
| | Magnetic iron oxide | Carbon-based fine particles | | | | | | | |
| Example 1 | Sr-Fe | CB | Silicone rubber | 1.6 | PP (honeycomb) | 9.7 | -14.4 | 0.0 | -15.4 |
| Example 2 | Sr-Fe | CB | Silicone rubber | 1.6 | PP (honeycomb) | 7.7 | -10.8 | 0.1 | -15.6 |
| Example 3 | Sr-Fe | CB | Silicone rubber | 1.6 | PP (foam) | 6.0 | -9.9 | 0.5 | -15.6 |
| Example 4 | Sr-Fe | none | Silicone rubber | 1.0 | PP (honeycomb) | 9.7 | -36.0 | 0.0 | -10.5 |
| Example 5 | Sr-Fe | CB | Silicone rubber | 1.6 | Acrylic plate | 10.0 | -8.8 | 0.0 | -15.4 |
| Example 6 | Sr-Fe | CNT | Silicone rubber | 1.6 | PP (honeycomb) | 9.7 | -18.1 | 0.0 | -20.4 |
| Example 7 | Sr-Fe | CB | Silicone rubber | 1.6 | PP (pladan) | 10.0 | -8.0 | 0.1 | -15.6 |
| Example 8 | none | CB | Silicone rubber | 1.6 | PP (honeycomb) | 9.7 | -11.4 | 0.1 | -12.1 |
| Comparative Example 1 | Sr-Fe | CB | Silicone rubber | 1.6 | none | - | (-5.7) | 12 | -16.0 |

As shown in Table 1, in all of Examples 1 to 8, the free-standing ability evaluation value Δ is 0.5 or less, and it can be judged that the free-standing ability is sufficient. In addition, the transmission attenuation amount when passing through an electric-wave absorber exhibiting electric-wave absorbing properties was -10 dB or more in all of the Examples, confirming that they have practically sufficient electric-wave absorbing properties.

On the other hand, the electric-wave absorber of Comparative Example 1, which does not have a reinforcing layer, had an extremely large free-standing ability evaluation value Δ of 12 mm, and thus it can be understood that the electric-wave absorbing layer alone cannot stand upright with its side surface facing the vertical direction.

As described above, the electric-wave absorber according to the present embodiment can free-stand due to including the reinforcing layer on the electric-wave incident side of the electric-wave absorbing layer, and thus it was confirmed that an electric-wave absorber with excellent handleability that can easily be arranged at a desired position was obtained.

It was also confirmed that the reflection attenuation amount on the surface of the electric-wave absorber is improved by arranging the above-described reinforcing layer made of the dielectric on the surface of the electric-wave absorber on which the electric waves are incident.

Specifically, in Table 1, when the reflection attenuation amounts of the electric-wave absorbers of Examples 1, 2, 3, 5, and 7 having the same electric-wave absorbing layer (electric-wave absorbing layer 1) and the transmission attenuation amounts of the electric-wave absorber of Comparative Example 1, which does not have a reinforcing layer, that is, the reflection attenuation amount (-5.7 dB) on the surface of the electric-wave absorbing layer, are compared, it can be understood that the reflection attenuation amount on the surface of the reinforcement layer is large.

In this manner, by arranging a reinforcing layer for increasing the free-standing ability on the electric-wave incident side surface of the electric-wave absorbing layer in the electric-wave absorber, reflection on the surface of the electric-wave absorber can also be suppressed. According to studies conducted the inventors, it was confirmed that it is preferable that the value of a ratio A/B is 1.5 or more and 6.5 or less, where A is the reflection attenuation amount (dB) on the surface of the reinforcing layer, which is the front surface of the electric-wave absorber, and B is the reflection attenuation amount (dB) on the surface of the electric-wave absorbing layer, which is the back surface of the electric-wave absorber (the attenuation amount in electric waves reflected on the surface of the electric-wave absorbing layer when electric waves are emitted from the back surface side).

### [Electric-Wave Absorbing Device]

An electric-wave absorbing device that absorbs unwanted electric waves using an electric-wave absorber according to this embodiment will be described below with specific examples.

As described above, the electric-wave absorber disclosed in the present application is capable of free-standing since it includes a reinforcing layer having a predetermined thickness and rigidity, together with the electric-wave absorbing layer. Taking advantage of this fact, for example, when measuring the electric-wave properties of a measurement target device, by arranging an electric-wave absorber on the path between unwanted electric waves reflected by a wall or the like and a measuring device, it is possible to effectively prevent the measuring device from capturing electric waves other than the electric waves from the measurement target device that is a target of measurement, and thus the electric-wave properties can be measured with a high S/N ratio.

Note that when an electric-wave absorber is arranged on the path between an unwanted electric wave and a measuring device in this manner, the electric-wave absorber alone is capable of free-standing, but considering that the electric-wave absorber is easily moved to a desired position to maintain its arrangement position and arrangement direction, it is preferable to use an electric-wave absorbing device with support members such as legs or support columns fixed to the electric-wave absorber rather than the electric-wave absorber alone, because the practicality is greatly improved. Note that the support member need only be a member that can keep the electric-wave absorber in a state in which the unwanted electric waves can be effectively absorbed, such as the position of the electric-wave absorber, and the orientation and inclination angle of the electric-wave incident surface, and the like. For this reason, it is possible to select a support member of a suitable form other than the above-mentioned legs and support columns, such as a support member that suspends the electric-wave absorber from a ceiling surface or a wall surface, or a support member that sandwiches the end of the electric-wave absorber.

Incidentally, in the electric-wave absorber disclosed in the present application, since the reinforcement layer made of a dielectric is arranged on the electric-wave incident side of the electric-wave absorbing layer, as described in the above embodiment, some of the electric waves incident on the electric-wave absorber are reflected on the surface of the reinforcing layer. The inventors have found that the reflection properties of electric waves on the surface of this reinforcing layer change depending on the inclination angle of the electric-wave incident surface with respect to electric waves incident on the electric-wave absorber. Also, based on these findings, the inventors have conducted studies on the inclination angle of the electric-wave incident surface that improves the electric-wave absorbing properties of the electric-wave absorber. The contents thereof are described below.

### [Relationship Between Inclination Angle of Electric-Wave Absorber and Electric-Wave Absorbing Properties]

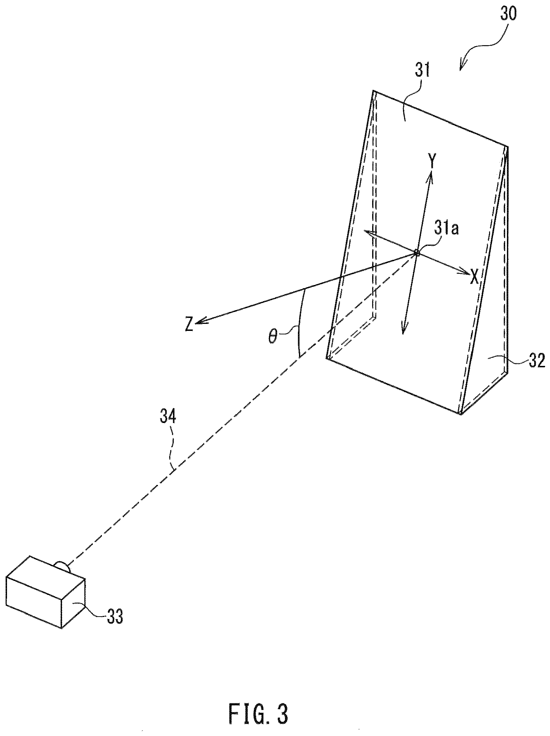

FIG. 3 is a diagram showing a state in which an electric-wave absorber is inclined as an example of the electric-wave absorbing device according to this embodiment.

The electric-wave absorbing device 30 illustrated in FIG. 3 is constituted by a flat plate-shaped electric-wave absorber 31, and two triangular support members 32 that are attached to side portions on both sides of the electric-wave absorber 31, so as to extend perpendicularly to the electric-wave incident surface, which is the main surface of the electric-wave absorber 31. By providing the support members 32 in this way, the electric-wave absorbing device 30 can be moved to be easily arranged at a predetermined position in a predetermined orientation while maintaining the state in which the electric-wave incident surface of the electric-wave absorber 31 is inclined at a predetermined angle.

Note that in the following description, it is assumed that the inclination angle of the electric-wave absorber 31 in the electric-wave absorbing device 30 according to the present embodiment refers to the angle formed by the traveling direction of the electric waves 34 to be absorbed (incident direction on the electric-wave absorber 31) and the direction (Z direction) of a normal line of a portion 31a on the electric-wave incident side of the electric-wave absorber 31 located on the traveling direction 34 of the electric wave, that is, the angle indicated as θ in FIG. 3. Also, the electric-wave absorbing device disclosed in the present application is characterized in that the direction of a normal line on the portion of the surface on the electric-wave incident side of the electric-wave absorber and the traveling direction of electric waves intersect at a predetermined angle, that is, θ is not 0°.

Here, the traveling direction 34 of the electric wave to be absorbed is understood to be the direction of a straight line connecting the distance between the electric-wave emission source (the device 33 in the case of FIG. 3) and the electric-wave absorber 31 so as to minimize the distance. Furthermore, the portion 31a on the electric-wave incident side of the electric-wave absorber 31 is a portion with a small surface area located in the traveling direction of the electric wave obtained as described above, and for example, regarding its size, it can be considered as a circular portion having a diameter of about 1/100 of the distance between the electric-wave emission source 33 and the electric-wave absorbing device 30 (a circular portion with a diameter of 3 cm when the distance is 3 m).

Based on the above definitions, for example, as shown in FIG. 3, if the electric wave 34 to be absorbed by the electric-wave absorber 31 is emitted in a horizontal direction from the device 33, which is the electric-wave emission source, the inclination angle θ of the electric-wave absorber 31 matches the angle formed by the electric-wave incident surface of the flat plate-shaped electric-wave absorber 31 and the vertical direction.

Also, if the electric-wave absorber is not flat, that is, if the surface of the electric-wave absorber is curved instead of flat plate-shaped, similarly, the angle formed by the normal direction at the portion of the electric-wave absorber on the electric-wave incident side in the traveling direction of the electric wave to be absorbed and the traveling direction of the electric wave is also defined as the inclination angle θ of the electric-wave absorber.

Note that if the surface of the electric-wave absorber is curved, it is conceivable that the curve direction is horizontal (X direction in FIG. 3), vertical (Y direction in FIG. 3), or a direction that is neither the X direction nor the Y direction. Furthermore, it is also conceivable that the surface of the electric-wave absorber is a substantially spherical surface, that is, the surface is curved in both the X direction and the Y direction. However, in any of these cases, since it is possible to determine the normal direction of the portion on the electric-wave incident side of the electric-wave absorber located in the travel direction of the electric wave, the inclination angle of the electric-wave absorber can be determined according to the above definition.

If the surface of the electric-wave absorber is a curved surface, it is conceivable that the surface is a convex surface, which protrudes on the side on which electric waves are incident, or that the surface is a concave surface that is recessed on the side on which electric waves are incident. However, in any case, since the normal direction of the portion of the surface of the electric-wave absorber can be found out, the inclination angle of the electric-wave absorber can be determined by the above definition.

Furthermore, if the surface of the electric-wave absorber has different heights, such as an uneven or wavy shape, the surface of the flat electric-wave absorber is defined using the average value of the height, and the inclination angle of the electric-wave absorber can be determined by determining the normal direction of the portion on the electric-wave incident side in the travel direction of the electric waves.

Note that the reflection attenuation amount, which is the electric-wave properties of the electric-wave absorber studied here, is a numeric value (dB) indicating to what extent the intensity of the electric waves received by the device for receiving the electric waves reflected by the surface of the electric-wave absorber has decreased compared to the intensity of the electric waves transmitted from the device that transmits the electric waves, and in the measurement method therefor, as described above, measurement is performed in a state where the device that transmits the electric waves and the device that receives the reflected electric waves are at the same position. Considering that electric waves travel in a straight line but spread out radially, the ratio by which electric waves reflected on the surface of the electric-wave absorber are scattered and return to the position of the transmission source is reduced when the surface of the electric-wave absorber is a curved shape or an uneven shape, compared to the case where the surface of the electric-wave absorber is flat. For this reason, in order to reduce the reflected waves on the surface on the electric-wave incident side of the electric-wave absorber and increase the reflection attenuation amount, it is preferable that the portion of the surface of the electric-wave absorber in the traveling direction of the electric waves is a curved surface that is curved in at least one direction instead of being flat. That is, it is conceivable that the reflection attenuation amount can be further reduced by using a curved surface in which the normal direction of the portion of the surface of the electric-wave absorber is inclined with respect to the traveling direction of the electric waves, rather than by using a flat surface in which the portion of the surface is inclined.

### <Changes in Electric-Wave Absorbing Properties Due to Inclination Angle of Electric-Wave Absorber>

As an Example, the inventors actually produced three types of electric-wave absorbers having reinforcing layers with different configurations, and measured how the electric-wave absorbing properties change by changing the inclination angle θ.

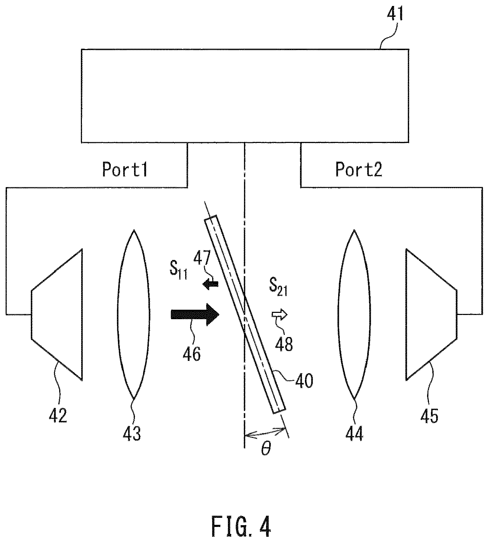

FIG. 4 is a schematic diagram showing a measurement system for measuring the relationship between the inclination angle of the electric-wave absorber and the electric-wave absorbing properties.

Changes in the electric-wave properties at the inclination angle of the electric-wave absorber were measured with the free space method using a millimeter-wave network analyzer ME7838A (product name: reference numeral 41) manufactured by Anritsu Co., Ltd., as in the above-described embodiment of the electric-wave absorber.

Specifically, as shown in FIG. 4, a 76.5-GHz input wave (reference numeral 46) was emitted from the transmission antenna 42 through the dielectric lens 43 to the electric-wave incident surface, which is the front surface side of the electric-wave absorber 40, that is, the side on which the reinforcing layer is arranged. At this time, a surface reflected wave Sn (reference numeral 47) reflected by the front surface of the electric-wave absorber 40 was received by the receiving antenna (reference numeral 42) through the dielectric lens 43. Also, a transmitted wave S₂₁ (reference numeral 48) transmitted to the back surface side of the electric-wave absorber 40, that is, the electric-wave absorbing layer side, was measured with the dielectric lens 44 and the receiving antenna 45 arranged on the back surface side.

Then, the angle θ of the electric-wave absorber 40 was gradually inclined from 0°, that is, the state of being vertically arranged, to 20°, the intensity of the electric waves emitted from the transmission antenna 42 and the intensity of the electric waves received by the receiving antennas 42 and 45 were measured respectively as voltage values, and the reflection attenuation amount on the surface of the electric-wave absorber and the transmission attenuation amount through the electric-wave absorber were each determined in dB.

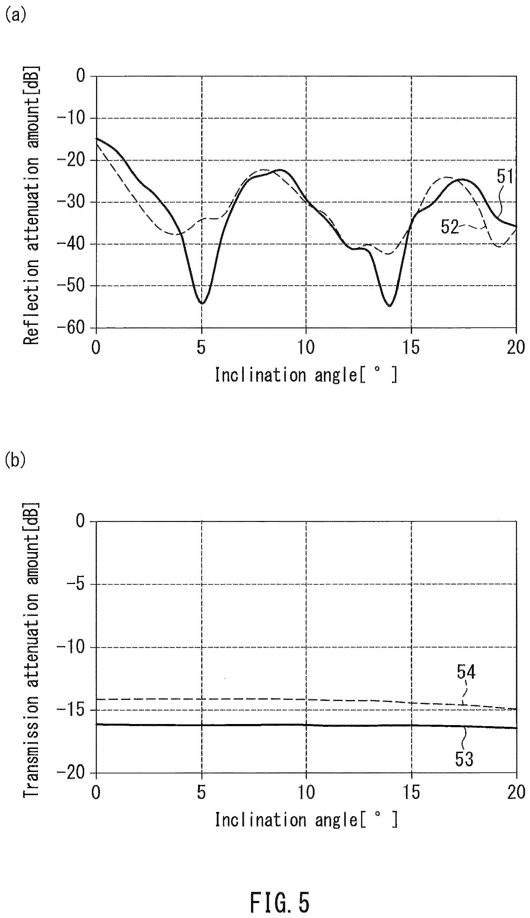

FIGS. 5 to 7 show the measurement results for the inclination angle and reflection attenuation amount, and the inclination angle and transmission attenuation amount of each electric-wave absorber. Note that in each graph of FIGS. 5 to 7, the change in the reflection attenuation amount with respect to the change in the inclination angle of the electric-wave absorber is represented as (a) in each figure, and the change in the transmission attenuation amount with respect to the change in the inclination angle of the electric-wave absorber is represented as (b) in each figure. Also, in each graph, the horizontal axis indicates the inclination angle θ (°) of the electric-wave absorber, and the vertical axis indicates the electric-wave attenuation amount (dB).

FIG. 5 shows the measurement result in the case of using the above-described polypropylene honeycomb core material (Teccell T10-2000 (product name, manufactured by Gifu Plastic Industry Co., Ltd., 9.7 mm thick: reinforcing layer 1) as the reinforcing layer, and using the above-described "electric-wave absorbing layer 1" as the electric-wave absorbing layer (same as the electric-wave absorber of Example 1).

As shown in FIG. 5(a), in both the case where the polarization direction of the emitted waves is a solid line 51 indicating a TE (electrical field) wave and a case where the polarization direction is a broken line 52 indicating a TM (magnetic field) wave, the reflection attenuation amount is greater between the inclination angles of 0° and 20° compared to the case where the inclination angle is 0°, that is , the electric waves are perpendicularly incident on the surface of the electric-wave absorber. However, it is understood that as the inclination angle increases, the value of the reflection attenuation amount does not increase uniformly, but the value of the reflection attenuation amount fluctuates slightly in a wave-like manner, and there is a range in which a larger reflection attenuation amount is obtained. In particular, it can be confirmed that the reflection attenuation amount of TE waves is 50 dB or more at the inclination angles near 5° and near 13°, indicating extremely high electric-wave absorbing properties.

On the other hand, in FIG. 5(b), which shows changes in the transmission attenuation amount, there is almost no change between the inclination angles of 0° and 20°, and a constant value of about -15 dB is shown in both the case where the polarization direction of the emitted waves is a solid line 53 indicating a TE (electric field) wave and the case where the polarization direction of the emitted waves is a broken line 54 indicating a TM (magnetic field) wave.

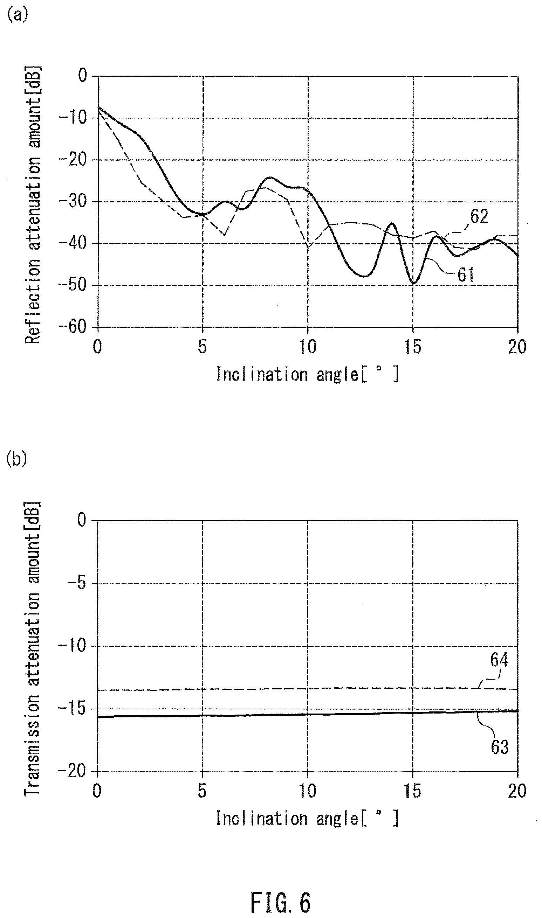

FIG. 6 shows a measurement result in the case of using a resin board (Plapearl (registered trademark) PGPPZ-200 (product name; manufactured by Kawakami Sangyo Co., Ltd., thickness 9 mm)), which is obtained by sandwiching, with resin boards from above and below, an air cap (foam cushioning material) having minute cylindrical projections filled with air arranged side by side as a reinforcing layer, and using the above-described "electric-wave absorbing layer 1" as the electric-wave absorbing layer.

As shown in FIG. 6(a), in both the case where the polarization direction of the emitted waves is a solid line 61 indicating TE (electric field) waves and a case where the polarization direction is a broken line 62 indicating TM (magnetic field) waves, the reflection attenuation amount is greater in the range up to the inclination angle of 20°, compared to when the inclination angle is 0°, that is, the electric waves are incident perpendicularly on the surface of the electric-wave absorber. Also, as the inclination angle increases, the value of the reflection attenuation amount changes to a larger numeric value overall while fluctuating slightly in a wave-like manner. Note that it can be understood that there is a region where both the solid line of reference numeral 61 indicating the electric field and the dotted line of reference numeral 62 indicating the electric field have large values around the inclination angles of 5° to 7°.

On the other hand, in FIG. 6(b), which shows the change in the transmission attenuation amount, there is almost no change between the inclination angles of 0° and 20°, as in the measurement results for the honeycomb core material made of polypropylene shown in FIG. 5(b), and a constant value of about -15 dB is shown in both the case where the polarization direction of the emitted waves is a solid line 63 indicating TE (electric field) waves and the case where the polarization direction is a broken line 64 indicating TM (magnetic field) waves.

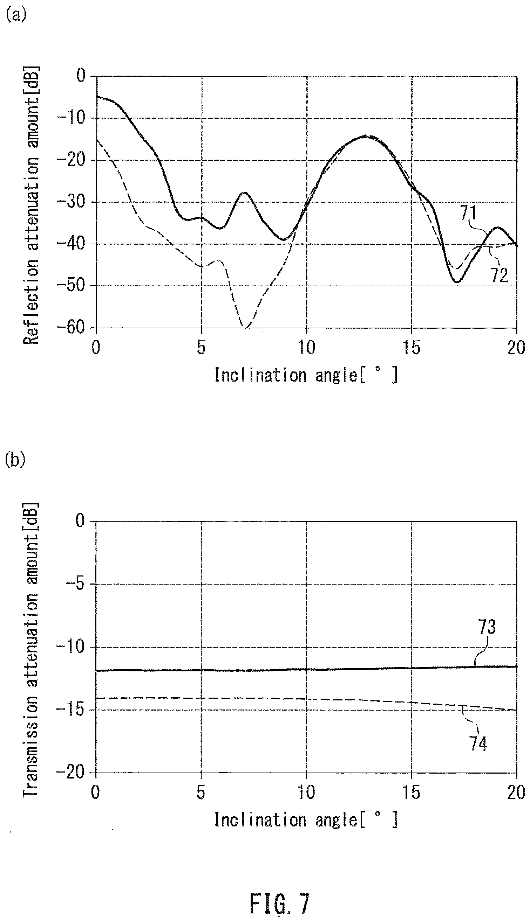

FIG. 7 shows the measurement result in the case of using, as a reinforcing layer, a resin hollow structural plate (DANPLATE (registered trademark) J-10-180 (product name, manufactured by Ube Exsymo Co., Ltd., thickness 10 mm)), which is a plastic cardboard made of polypropylene and is formed by arranging perpendicular walls that are aligned in one direction and covered by upper and lower flat plates, and using the above-described "electric-wave absorbing layer 1" as the electric-wave absorbing layer.

As shown in FIG. 7(a), in both the case where the polarization direction of the emitted waves is a solid line 71 indicating TE (electric field) waves and the case where the polarization direction is a broken line 72 indicating TM (magnetic field) waves, the reflection attenuation amount is greater in the range up to the inclination angle of 20°, compared to the case where the inclination angle is 0°, that is, the electric waves are perpendicularly incident on the surface of the electric-wave absorber. If the hollow structural plate shown in FIG. 7(a) is used as the reinforcing layer, the change in the reflection attenuation amount due to the change in the inclination angle is the largest and changes in a wave-like manner, but can be understood that there is a region around 4° to 7° where both the solid line of reference numeral 71 indicating the electric field and the dotted line of reference numeral 72 indicating the electric field have large values.

On the other hand, in FIG. 7(b), which shows changes in the transmission attenuation amount, as with the measurement results for the polypropylene honeycomb core material shown in FIG. 5(b) and the resin board using the air cap shown in FIG. 6(b), there is almost no change between the inclination angles of 0° and 20°, a constant value of about 12 dB is shown when the polarization direction of the emitted waves is a solid line 73 indicating TE (electric field) waves, and a constant value of about -14 dB is shown when the polarization direction is a broken line 74 indicating TM (magnetic field) waves.

In this way, it is understood that in the cases of both reinforcing layers, the reflection attenuation amount of the electric waves reflected by the surface of the reinforcing layer arranged on the electric-wave incident side of the electric-wave absorber is larger when any reinforcing layer is inclined at an angle of 2° or more and 20° or less, compared to the case of not being inclined (inclination angle is 0°). Also, it was confirmed that although the magnitude of change in the reflection attenuation amount varies depending on the shape of the space inside the reinforcing layer, the reflection attenuation amount does not gradually increase according to the inclination angle, but there is a region of the inclination angles at which the reflection attenuation amount increases and a region of inclination angles at which the reflection attenuation amount is relatively smaller. As shown in FIGS. 5 to 7, it was confirmed that the reflection attenuation amount increases in the region of the inclination angle of 3° or more and 7° or less.

Although it is not clear why the overall attenuation amount increases while the reflection attenuation amount varies depending on the inclination angle, when electric waves pass through a honeycomb core material, a hollow structure, or a structure with bubbles, the distance by which the electric waves pass through materials with different permittivities and air differs depending on the inclination angle, and therefore it is inferred that the reflection attenuation amount increased while waving depending on the inclination angle.

As described above, it was confirmed that the trend of the change in the reflection attenuation amount with respect to the angle of incident electric waves vary depending on the configuration of the reinforcing layer, and in particular, depending on the arrangement of air contained in the reinforcing layer. Note that it is conceivable that the degree of increase or decrease in the reflection attenuation amount with respect to the inclination angle is greater in a configuration in which a space between upper and lower flat plates is not divided in a thickness direction as with the honeycomb core material shown in FIG. 5 and the plastic cardboard shown in FIG. 7, compared to a configuration in which air is confined in a space that is limited in the thickness direction as with the resin board using the air cap shown in FIG. 6.

For this reason, it is envisioned that if a partitioning member that is not divided in the thickness direction is arranged between the upper and lower flat plates, the trend of the change in the reflection attenuation amount due to the inclination angle is similar regardless of the shape of the partitioning member, such as a lattice shape in which partitioning members intersects horizontally and vertically at right angles, a lattice shape in which partitioning members intersect obliquely so as to form a diamond shape, and a form in which a plurality of circular columns are arranged side by side, in addition to a honeycomb shape and a linear shape in one direction. Also, for example, in the case where the leading ends of conical members arranged on both the upper plate member and the lower plate member are joined together to form a partitioning member, or the partitioning member is arranged in a wavy shape in the thickness direction, it is presumed that, like the resin board shown in FIG. 6, the change in the reflection and absorbing properties at the inclination angle will tend to be small.

In addition, if the reinforcing layer is made of foam, it is conceivable that the degree of change in the reflection attenuation amount with respect to the change in the inclination angle is the smallest, but it is conceivable that the reflection attenuation amount can be increased by setting the inclination angle to 2° or more and 20° or less.

As described above, the electric-wave absorber shown in the present embodiment favorably absorbs electric waves in a frequency band of 20 GHz to 300 GHz and is capable of free-standing as an electric-wave absorber, due to including an electric-wave absorbing layer in which at least one of magnetic iron oxide and carbon-based fine particles that magnetically resonate in a frequency band of 20 GHz to 300 GHz is dispersed and mixed in a resin binder, and a reinforcing layer that is made of a dielectric material and arranged on the electric-wave incident side of the electric-wave absorbing layer. For this reason, for example, when measuring electric-wave properties, it is possible to protect the measuring device and the measurement target device from unwanted electric waves by arranging the electric-wave absorber like a screen at a position at which unnecessary electric waves are blocked, and it is possible to perform measurement of electric-wave properties in a favorable environment with little noise.

Also, the electric-wave absorbing device shown in this embodiment is an electric-wave absorbing device using the electric-wave absorber disclosed in the present application, and includes an electric-wave absorber, and a support member that can keep the surface on the electric-wave incident side of the electric-wave absorber at a predetermined angle, and is arranged such that that the normal direction of the portion of the surface on the electric-wave incident side located in the traveling direction of the electric waves to be absorbed and the traveling direction of the electric waves intersect each other at a predetermined angle. For this reason, it is possible to realize an electric-wave absorbing device that can easily keep the electric-wave absorber in a state of being inclined at a predetermined inclination angle, suppress the reflection of electric waves on the surface of the reinforcing layer, has favorable reflection attenuation properties, and can be easily arranged at a desired position.

Note that in the above-described embodiment, the main surfaces of the electric-wave absorbing layer and the reinforcing layer of the electric-wave absorber were described as being rectangular and having the same size, but the shapes and sizes of the main surfaces of the electric-wave absorbing layer and the reinforcing layer do not necessarily need to be the same, and as long as the shape can sufficiently block the path of unwanted electric waves to be blocked by the electric-wave absorber, there is no problem even if one of them is larger than the other and partially protrudes. Also, even if the planar shape of the electric-wave absorbing layer is complicated with protrusions, recesses, and voids formed therein, a reinforcing layer having a planar shape such as a rectangle, circle, or polygon larger than the electric-wave absorber may also be used as long as the reinforcing layer has a shape according to which the entirety thereof can be kept in a substantially vertical direction.

### Industrial Applicability

The electric-wave absorber disclosed in the present application favorably absorbs electric waves of 20 GHz to 300 GHz and is capable of free-standing, and therefore it can be easily arranged in the path of electric waves to be absorbed. Also, an electric-wave absorbing device capable of maintaining a state in which the electric-wave absorber is inclined at a predetermined inclination angle can be easily used in a state in which the reflection of electric waves on the surface of the reflective layer is reduced. For this reason, it is useful as an electric-wave absorbing member capable of forming a favorable space in which the influence of unwanted electric waves is suppressed.

### Description of Reference Numerals

- 1: Electric-wave absorbing layer
- 1a: Magnetic iron oxide powder
- 1b: Carbon-based fine particles
- 1c: Resin binder
- 2: Reinforcing layer
- 10: Electric wave (incident wave)
- 30: Electric-wave absorbing device
- 31: Electric-wave absorber
- 32: Support member

## Claims

1. An electric-wave absorber comprising:
an electric-wave absorbing layer; and
a reinforcing layer disposed on a surface on an electric-wave incident side of the electric-wave absorbing layer,
wherein the electric-wave absorbing layer contains a resin binder and at least one of magnetic iron oxide powder and carbon-based fine particles that magnetically resonate in a frequency band of 20 GHz to 300 GHz,
the reinforcing layer is constituted by a dielectric material, and
the electric-wave absorber has a plate shape with a small thickness with respect to a main surface and is capable of free-standing.

2. The electric-wave absorber according to claim 1, wherein the magnetic iron oxide powder is either magnetoplumbite-type ferrite powder or epsilon magnetic iron oxide powder.

3. The electric-wave absorber according to claim 1 or 2, wherein the carbon-based fine particles are at least one of carbon black, carbon nanotubes, and graphene.

4. The electric-wave absorber according to any one of claims 1 to 3, wherein the resin binder is a rubber-based member.

5. The electric-wave absorber according to any one of claims 1 to 4, wherein in a free-standing ability test for the electromagnetic-wave absorber, a Δ value indicating a degree of deformation of an electric-wave absorber sample is 0.5 mm or less.

6. The electric-wave absorber according to any one of claims 1 to 5, wherein an electric-wave attenuation amount for transmitted electric waves passing through the electric-wave absorber is -10 dB or more.

7. The electric-wave absorber according to any one of claims 1 to 6, wherein the reinforcing layer includes one selected from a reinforcing plate material having a honeycomb structure, a foam plate material, plastic cardboard, and a plastic plate material.

8. The electric-wave absorber according to any one of claims 1 to 6, wherein the reinforcing layer includes any one of a reinforcing plate material having a honeycomb structure, a foam plate material, and plastic cardboard.

9. An electric-wave absorbing device using the electric-wave absorber according to any one of claims 1 to 8, comprising:
the electric-wave absorber; and
a support member capable of keeping the surface on the electric-wave incident side of the electric-wave absorber at a predetermined angle,
wherein the electric-wave absorber is arranged such that a normal direction of a portion of the surface on the electric-wave incident side located in a traveling direction of electric waves to be absorbed intersects with the traveling direction of the electric waves at a predetermined angle.

10. The electric-wave absorbing device according to claim 9, wherein a portion of the surface is a curved surface curved in at least one direction.

11. The electric-wave absorbing device according to claim 9 or 10, wherein an angle at which a normal direction of the portion of the surface intersects with the travel direction of the electric waves is 2° or more and 20° or less.

12. The electric-wave absorbing device according to claim 11, wherein the intersecting angle is 3° or more and 7° or less.
